# EUROPEAN PATENT APPLICATION

(11) **EP 4 692 159 A1**
(43) Date of publication of application: **11.02.2026**
(21) Application number: 24779560.2
(22) Date of filing: 15.03.2024
(51) Int. Cl.: C08G 59/58, C08G 8/06, C08G 59/08, C08J 5/04, H01L 23/29, H01L 23/31, H05K 1/03

(54) **CURABLE RESIN COMPOSITION AND CURED PRODUCT THEREOF**

(30) Priority: 30.03.2023 JP 2023055545
(71) Applicant: Nippon Kayaku Kabushiki Kaisha, Tokyo 100-0005 (JP)
(72) Inventor: IMAI Takashi, Tokyo 115-8588 (JP); TERADA Kiwamu, Tokyo 115-8588 (JP); NAKANISHI Masataka, Tokyo 115-8588 (JP); KONDO Hiroki, Tokyo 115-8588 (JP)
(74) Representative: Becker, Eberhard
(86) International application number: PCT/JP2024/010167
(87) International publication number: WO 2024/203431

(57) **Abstract**

The present invention provides: a curable resin composition having a high degree of biomass and having excellent high heat resistance and low dielectric properties; and a cured product of the curable resin composition. The curable resin composition comprises an epoxy resin represented by formula (1) and an acid anhydride curing agent comprising a biomass-derived compound. (In formula (1), n is the average number of repeating units, and represents a real number within the range 1<n<15.)

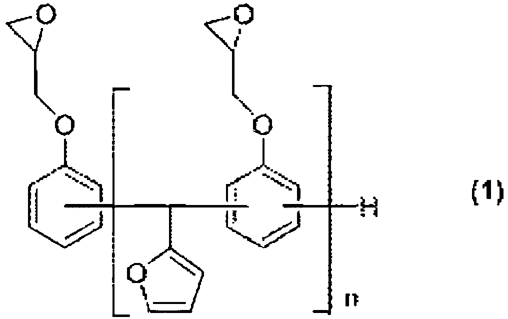

## Description

### Technical Field

The present invention relates to a curable resin composition including a specific epoxy resin and a specific acid anhydride and a cured product thereof, and is suitably used in the fields of electrical and electronic components such as semiconductor device encapsulants, printed wiring boards, and buildup laminates, lightweight high-strength materials such as carbon fiber reinforced plastics and glass fiber reinforced plastics, 3D printing applications, and adhesives.

### Description of Related Art

Epoxy resins are widely used in the fields of electrical and electronic components, structural materials, adhesives, coatings, etc. due to the workability and the exemplary electrical properties, heat resistance, adhesion, and moisture resistance (water resistance) of cured products thereof. In recent years, particularly in the electrical and electronic field, further improvement of various resin properties such as heat resistance, low dielectric constant, and low dielectric loss tangent has been required along with the development thereof. Also, as structural materials, lightweight materials with exemplary mechanical properties are required in aerospace materials, leisure and sports equipment applications, etc.

Also, in recent years, biomass resources have been attracting attention as carbon-neutral resources from the viewpoint of environmental issues. Furfural is known as a biomass-derived compound, and Patent Literature 1 discloses an epoxy resin using furfural as a raw material.

### Related Art

### Patent Literature

Patent Literature 1: Japanese Patent Application Laid-Open No. 2007-211254

### SUMMARY

### Technical Problem

However, since Patent Literature 1 forms an epoxy resin composition by mixing an epoxy resin using furfural as a raw material with a phenol novolac resin which is a petrochemical-derived curing agent, the biomass content of the composition is low.

Generally, in the case of attempting to increase the biomass content, it becomes difficult to maintain the performance required for curable resin compositions, so there has been a demand for curable resin compositions that have high biomass content while satisfying the required characteristics.

The present invention has been made in view of the above situation, and aims to provide a curable resin composition that has high biomass content and is exemplary in high heat resistance and low dielectric properties and a cured product thereof.

### Solution to the Problem

That is, the present invention relates to the following [1] to [9]. In the present invention, "(numerical value 1) to (numerical value 2)" indicates that the upper and lower limit values are included.
[1] A curable resin composition includes an epoxy resin represented by the following formula (1) and a biomass-modified acid anhydride. 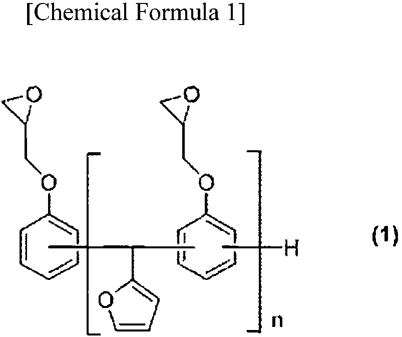 (In formula (1), n is an average value of the number of repetitions and represents a real number where 1<n<15.)
[2] In the curable resin composition according to the above [1], the biomass-modified acid anhydride is at least one selected from myrcene-modified acid anhydride, farnesene-modified acid anhydride, and α-terpinene-modified acid anhydride.
[3] In the curable resin composition according to the above [1] or [2], the biomass content of the biomass-modified acid anhydride is 20% or more.
[4] In the curable resin composition according to any one of the above [1] to [3], the ICI viscosity (150°C) of the epoxy resin is 0.01 to 0.20 Pa·s.
[5] In the curable resin composition according to any one of the above [1] to [4], the biomass content is 20% or more.
[6] The curable resin composition according to any one of the above [1] to [5] is for a carbon fiber reinforced plastic.
[7] The curable resin composition according to any one of the above [1] to [5] is for a semiconductor device encapsulant.
[8] The curable resin composition according to any one of the above [1] to [5] is for a printed wiring board.
[9] A cured product is obtained by curing the curable resin composition according to any one of the above [1] to [8].

### Effects

The present invention relates to a curable resin composition having high biomass content and exemplary high heat resistance and low dielectric properties. Therefore, the present invention is useful for insulating materials for electrical and electronic components (such as high-reliability semiconductor encapsulant materials), laminates (such as printed wiring boards and buildup substrates), various composite materials including CFRP, adhesives, and the like.

### BRIEF DESCRIPTION OF THE DRAWINGS

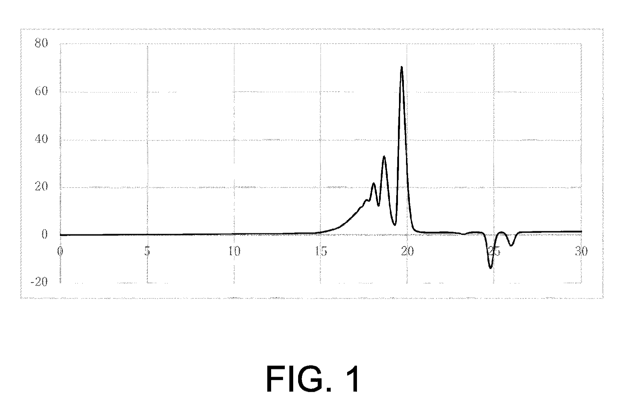

FIG. 1 shows a GPC chart of Synthesis Example 1.

### DESCRIPTION OF EMBODIMENTS

A curable resin composition of the embodiment contains an epoxy resin represented by the following formula (1) and a biomass-modified acid anhydride.

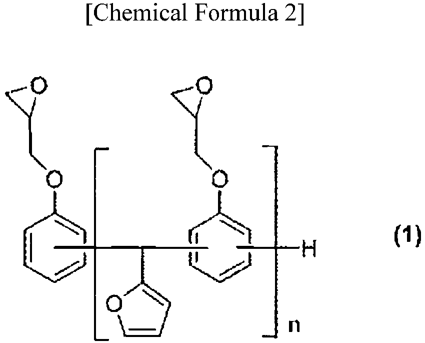

(In formula (1), n is an average value of the number of repetitions and represents a real number where 1<n<15.)

In the above formula (1), the value of n can be calculated from the number average molecular weight determined by measurement of the epoxy resin by gel permeation chromatography (GPC, detector: RI), or from the area ratio of each of separated peaks. n is preferably a real number where 1<n<15, more preferably 1<n<10, and particularly preferably 1<n<5.

The epoxy resin represented by the above formula (1) can be obtained by reacting a phenolic resin represented by the following formula (2) with epihalohydrin.

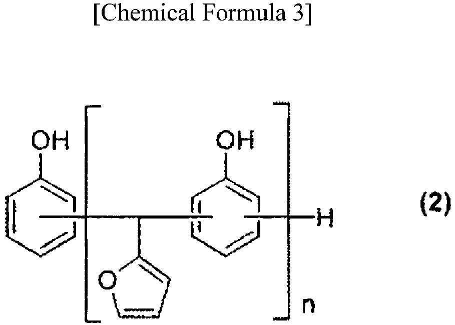

(In formula (2), n is an average value of the number of repetitions and represents a real number where 1<n<15.)

The preferable range of n in the above formula (2) is the same as in the above formula (1).

The epihalohydrin can be easily obtained from the market. The usage amount of epihalohydrin is preferably 2.0 to 10 mol, more preferably 3.0 to 8.0 mol, and further preferably 3.5 to 6.0 mol, per 1 mol of hydroxyl groups in the raw material phenol mixture.

In the above reaction, an alkali metal hydroxide can be used as a catalyst to promote the epoxidation step. Examples of alkali metal hydroxides that can be used include sodium hydroxide, potassium hydroxide etc., and a solid may be utilized or an aqueous solution thereof may be used. However, in the embodiment, the use of a solid formed into a flake shape is particularly preferable from the viewpoints of solubility and handling.

The usage amount of the alkali metal hydroxide is preferably 0.90 to 1.5 mol, more preferably 0.95 to 1.25 mol, and further preferably 0.99 to 1.15 mol, per 1 mol of hydroxyl groups in the raw material phenol mixture.

Additionally, quaternary ammonium salts such as tetramethylammonium chloride, tetramethylammonium bromide, trimethylbenzylammonium chloride, etc. may be added as catalysts to promote the reaction. The usage amount of the quaternary ammonium salt is preferably 0.1 to 15 g, more preferably 0.2 to 10 g, per 1 mol of hydroxyl groups in the raw material phenol mixture.

The reaction temperature is preferably 30 to 90°C, more preferably 35 to 80°C. Particularly in the embodiment, 50°C or higher is preferable for higher purity epoxidation, and 60°C or higher is especially preferable. The reaction time is preferably 0.5 to 10 hours, more preferably 1 to 8 hours, and particularly preferably 1 to 3 hours. In the case of a short reaction time, the reaction does not proceed completely, and in the case of a long reaction time, by-products are formed, which is not preferable.

The reaction products of the epoxidation reactions are washed with water, or epihalohydrin, solvents, etc. are removed under heating and reduced pressure without water washing. Furthermore, in order to obtain an epoxy resin with less hydrolyzable halogen, the recovered epoxy resin can be dissolved using a ketone compound having 4 to 7 carbon atoms (for example, methyl isobutyl ketone, methyl ethyl ketone, cyclopentanone, cyclohexanone, etc.) as a solvent, and an aqueous solution of an alkali metal hydroxide such as sodium hydroxide or potassium hydroxide can be added to conduct a reaction to ensure ring closure. In this case, the usage amount of the alkali metal hydroxide is preferably 0.01 to 0.3 mol, more preferably 0.05 to 0.2 mol, per 1 mol of hydroxyl groups in the raw material phenol mixture used for epoxidation. The reaction temperature is preferably 50 to 120°C, and the reaction time is preferably 0.5 to 2 hours.

After completion of the reaction, the generated salt is removed by filtration, water washing, etc., and the solvent is further distilled off under heating and reduced pressure to obtain the epoxy resin represented by the above formula (1).

As a synthesis method for the phenolic resin represented by the above formula (2), in the case of conducting a reaction (condensation) between furfural and phenols, the amount of phenols is preferably in the range of 1.5 to 20 mol, particularly preferably 3 to 10 mol, per 1 mol of furfural.

Examples of phenols include disubstituted phenols such as catechol, resorcinol, and hydroquinone, and monosubstituted phenols such as phenol, and they may be used alone or in combination of two or more types.

Examples of solvents include methanol, ethanol, propanol, isopropanol, toluene, xylene, etc., but are not limited thereto, and the aforementioned may be used alone or in combination of two or more types. In the case of using a solvent, the usage amount is preferably 5 to 500 parts by weight, more preferably in the range of 10 to 300 parts by weight, per 100 parts by weight of phenol.

In the above condensation reaction, it is preferable to use a basic catalyst. Although polycondensation is possible with an acidic catalyst, reactions between furfurals also occur, resulting in increased by-products. There is also a method using organometallic compounds, but the method is disadvantageous in terms of cost. Specific examples of basic catalysts include alkali metal hydroxides such as lithium hydroxide, sodium hydroxide, and potassium hydroxide; alkaline earth metal hydroxides such as magnesium hydroxide and calcium hydroxide; alkali metal alkoxides such as sodium methoxide, sodium ethoxide, potassium methoxide, potassium ethoxide, and potassium-tert-butoxide; and alkaline earth metal alkoxides such as magnesium methoxide and magnesium ethoxide, but are not limited thereto, and they may be used alone or in combination of two or more types. The usage amount of the catalyst is preferably 0.005 to 2.0 times the molar amount, more preferably 0.01 to 1.1 times the molar amount, per 1 mol of phenol.

The condensation reaction in the presence of the basic catalysts is preferably conducted in the range of 40 to 180°C, particularly preferably in the range of 80 to 165°C, and the reaction time is preferably selected in the range of 0.5 to 10 hours. The reaction product thus obtained is neutralized so that the system becomes neutral or subjected to repeated water washing in the presence of a solvent, and after separating and draining water, the solvent and unreacted materials are removed under heating and reduced pressure to obtain the phenolic resin represented by the above formula (2).

The curable resin composition of the embodiment contains a biomass-modified acid anhydride together with the epoxy resin represented by the above formula (1). The biomass-modified acid anhydride is an acid anhydride modified using biomass raw materials, and examples include myrcene-modified acid anhydride, farnesene-modified acid anhydride, and α-terpinene-modified acid anhydride. The aforementioned can be obtained by reacting terpene compounds such as myrcene, farnesene, and α-terpinene with acid anhydrides such as maleic anhydride, itaconic anhydride, and citraconic anhydride. The curable resin composition of the embodiment may also use acid anhydrides other than biomass-modified acid anhydrides in combination, for example, phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride. The aforementioned can be used in any proportion, but it is preferable that the proportion of biomass-modified acid anhydride in the total amount of acid anhydrides used is 30 to 100% by weight, as this can increase the biomass content. The acid anhydride is preferably 0.7 to 1.2 equivalents per 1 equivalent of epoxy groups in the epoxy resin represented by the above formula (1). In the case of less than 0.7 equivalents or exceeding 1.2 equivalents per 1 equivalent of epoxy groups, curing becomes incomplete in either case, and good cured properties may not be obtained.

From the viewpoint of environmental issues, the biomass content of the epoxy resin represented by the above formula (1) is preferably 20% or more. The biomass content of the biomass-modified acid anhydride is preferably 20% or more, more preferably 40% or more, and particularly preferably 60% or more. The biomass content of the curable resin composition of the embodiment is preferably 20% or more, more preferably 30% or more, and particularly preferably 40% or more. The upper limit of the biomass content is not particularly limited and may be 100%, but is preferably 60% in consideration of the balance with cured properties. A high biomass content can also reduce the usage amount of fossil resource-based materials represented by petroleum, etc., which is also significant from the viewpoint of sustainable use of resources.

The biomass content of each of materials and the curable resin composition can be determined by accelerated gravimetric analysis in accordance with ASTM D6866-21.

In the curable resin composition of the embodiment, the epoxy resin represented by the above formula (1) can be used alone or in combination with other epoxy resins. In the case of combined use, the proportion of the epoxy resin represented by the above formula (1) in the total epoxy resin is preferably 5 to 95% by weight, more preferably 10 to 95% by weight, and still more preferably 15 to 95% by weight. In the case of a small addition amount, sufficient heat resistance may not be exhibited.

Specific examples of epoxy resins that can be used in combination with the epoxy resin represented by the above formula (1) include polycondensates of bisphenols (bisphenol A, bisphenol F, bisphenol S, biphenol, bisphenol AD, etc.) or phenols (phenol, alkyl-substituted phenol, aromatic-substituted phenol, naphthol, alkyl-substituted naphthol, dihydroxybenzene, alkyl-substituted dihydroxybenzene, dihydroxynaphthalene, etc.) with various aldehydes (formaldehyde, acetaldehyde, alkyl aldehyde, benzaldehyde, alkyl-substituted benzaldehyde, hydroxybenzaldehyde, naphthaldehyde, glutaraldehyde, phthalaldehyde, crotonaldehyde, cinnamaldehyde, etc.); polymers of the above phenols with various diene compounds (dicyclopentadiene, terpenes, vinylcyclohexene, norbornadiene, vinylnorbornene, tetrahydroindene, divinylbenzene, divinylbiphenyl, diisopropenylbiphenyl, butadiene, isoprene, etc.); polycondensates of the above phenols with ketones (acetone, methyl ethyl ketone, methyl isobutyl ketone, acetophenone, benzophenone, etc.); polycondensates of the above phenols with aromatic dimethanols (benzenedimethanol, biphenyldimethanol, etc.); polycondensates of the above phenols with aromatic dichloromethyls (α,α'-dichloroxylene, bischloromethylbiphenyl, etc.); polycondensates of the above phenols with aromatic bisalkoxymethyls (bismethoxymethylbenzene, bismethoxymethylbiphenyl, bisphenoxymethylbiphenyl, etc.); glycidyl ether epoxy resins obtained by glycidylating polycondensates of the above bisphenols with various aldehydes or alcohols, etc., alicyclic epoxy resins, glycidylamine epoxy resins, glycidyl ester epoxy resins, etc. Specific examples of epoxy resins containing plant-derived components include compounds obtained by epoxidizing polycondensates prepared by polycondensing cardanol derived from cashew oil as the above phenols with various aldehydes, and compounds obtained by epoxidizing linseed oil or soybean oil. The epoxy resins are not limited thereto as long as they are commonly used epoxy resins. The aforementioned may be used alone or two or more types may be used. It is particularly preferable to use the epoxy resins in combination with epoxy resins containing plant-derived components because the biomass content can be increased.

The curable resin composition of the embodiment may use curing agents other than acid anhydrides in combination. For example, amine compounds, amide compounds, phenolic compounds, active ester compounds, etc. can be mentioned. Specific examples of curing agents that can be used in combination include amide compounds such as dicyandiamide and polyamide resins synthesized from dimers of linolenic acid and ethylenediamine; aromatic amine compounds such as o-phenylenediamine, m-phenylenediamine, p-phenylenediamine, 4,4'-diaminodiphenylsulfone, 3,4'-diaminodiphenylsulfone, 3,3'-diaminodiphenylsulfone, 2,2'-diaminodiphenylsulfone, diethyltoluenediamine, dimethylthiotoluenediamine, diaminodiphenylmethane, 3,3'-dimethyl-4,4'-diaminodiphenylmethane, 3,3'-diethyl-4,4'-diaminodiphenylmethane, 4,4'-diamino-3,3'-diethyl-5,5'-dimethyldiphenylmethane, 4,4'-diamino-3,3',5,5'-tetramethyldiphenylmethane, 4,4'-diamino-3,3',5,5'-tetraethyldiphenylmethane, 4,4'-diamino-3,3',5,5'-tetraisopropyldiphenylmethane, 4,4'-methylenebis(N-methylaniline), bis(aminophenyl)fluorene, 3,4'-diaminodiphenyl ether, 4,4'-diaminodiphenyl ether, 2,2'-bis[4-(4-aminophenoxy)phenyl]propane, bis[4-(4-aminophenoxy)phenyl]sulfone, 1,3'-bis(4-aminophenoxy)benzene, 1,4'-bis(4-aminophenoxy)benzene, 1,4'-bis(4-aminophenoxy)biphenyl, 4,4'-(1,3-phenylenediisopropylidene)bisaniline, 4,4'-(1,4-phenylenediisopropylidene)bisaniline, naphthalenediamine, benzidine, dimethylbenzidine; aliphatic amine compounds such as 1,3-bis(aminomethyl)cyclohexane, isophoronediamine, 4,4'-methylenebis(cyclohexylamine), norbornanediamine, ethylenediamine, propanediamine, tetramethylenediamine, pentamethylenediamine, hexamethylenediamine, dimer diamine, triethylenetetramine; phenolic compounds such as polycondensates of bisphenols (bisphenol A, bisphenol F, bisphenol S, biphenol, bisphenol AD, etc.) or phenols (phenol, alkyl-substituted phenol, aromatic-substituted phenol, naphthol, alkyl-substituted naphthol, dihydroxybenzene, alkyl-substituted dihydroxybenzene, dihydroxynaphthalene, etc.) with various aldehydes (formaldehyde, acetaldehyde, alkyl aldehyde, benzaldehyde, alkyl-substituted benzaldehyde, hydroxybenzaldehyde, naphthaldehyde, glutaraldehyde, phthalaldehyde, crotonaldehyde, cinnamaldehyde, etc.), or polymers of the above phenols with various diene compounds (dicyclopentadiene, terpenes, vinylcyclohexene, norbornadiene, vinylnorbornene, tetrahydroindene, divinylbenzene, divinylbiphenyl, diisopropenylbiphenyl, butadiene, isoprene, etc.), or polycondensates of the above phenols with ketones (acetone, methyl ethyl ketone, methyl isobutyl ketone, acetophenone, benzophenone, etc.), or polycondensates of the above phenols with aromatic dimethanols (benzenedimethanol, biphenyldimethanol, etc.), or polycondensates of the above phenols with aromatic dichloromethyls (α,α'-dichloroxylene, bischloromethylbiphenyl, etc.), or polycondensates of the above phenols with aromatic bisalkoxymethyls (bismethoxymethylbenzene, bismethoxymethylbiphenyl, bisphenoxymethylbiphenyl, etc.), or polycondensates of the above bisphenols with various aldehydes, and modified products thereof; active ester compounds such as phenol esters, thiophenol esters, N-hydroxyamine esters, esters of heterocyclic hydroxy compounds; etc., but are not limited thereto.

The curable resin composition of the embodiment may use a curing accelerator in combination without any issue. Examples of curing accelerators that can be used include imidazoles such as 2-methylimidazole, 2-ethylimidazole, 2-phenylimidazole, 2-ethyl-4-methylimidazole; tertiary amines such as 2-(dimethylaminomethyl)phenol, triethylenediamine, triethanolamine, 1,8-diazabicyclo[5,4,0]undecene-7; organic phosphines such as triphenylphosphine, diphenylphosphine, tributylphosphine; metal compounds such as tin octylate; tetra-substituted phosphonium·tetra-substituted borates such as tetraphenylphosphonium·tetraphenylborate, tetraphenylphosphonium·ethyltriphenylborate; tetraphenylboron salts such as 2-ethyl-4-methylimidazole-tetraphenylborate, N-methylmorpholine·tetraphenylborate; carboxylic acid compounds such as benzoic acid, phthalic acid, isophthalic acid, terephthalic acid, naphthoic acid, salicylic acid. The curing accelerator is used as needed in an amount of 0.01 to 15 parts by weight relative to 100 parts by weight of epoxy resin.

The curable resin composition of the embodiment can have an inorganic filler added as needed. Examples of inorganic fillers include powders such as crystalline silica, fused silica, alumina, zircon, calcium silicate, calcium carbonate, silicon carbide, silicon nitride, boron nitride, zirconia, forsterite, steatite, spinel, titania, talc, or beads obtained by spheroidizing the aforementioned, but are not limited thereto. The aforementioned may be used alone or two or more types may be used. The usage amount of the inorganic fillers varies depending on the application, but in the case of use for semiconductor device encapsulant applications, for example, it is preferable to use the inorganic fillers in a proportion occupying 20% by weight or more in the curable resin composition from the viewpoints of heat resistance, moisture resistance, mechanical properties, flame retardancy, etc. of the cured product of the curable resin composition, more preferably 30% by weight or more, and particularly preferably in a proportion occupying 70 to 95% by weight in order to improve the coefficient of linear expansion with the lead frame.

The curable resin composition of the embodiment can include a release agent to improve mold release during molding. Any conventionally known release agents can be used, including for example ester-based waxes such as carnauba wax and montan wax, fatty acids such as stearic acid and palmitic acid and metal salts thereof, and polyolefin-based waxes such as oxidized polyethylene and non-oxidized polyethylene. The aforementioned may be used alone or two or more types may be used in combination. The blend amount of the release agents is preferably 0.5 to 3% by weight relative to the total organic components. In the case of less than the above amount, mold release becomes poor, and in the case of more than the above amount, adhesion with lead frames and the like becomes poor.

The curable resin composition of the embodiment can include a coupling agent to enhance adhesion between the inorganic filler and resin components. Any conventionally known coupling agents can be used, including for example various alkoxysilane compounds such as vinylalkoxysilane, epoxyalkoxysilane, styrylalkoxysilane, methacryloxyalkoxysilane, acryloxyalkoxysilane, aminoalkoxysilane, mercaptoalkoxysilane, and isocyanate alkoxysilane, alkoxytitanium compounds, aluminum chelates, and the like. The aforementioned may be used alone or two or more types may be used in combination. The method of adding the coupling agent may involve pretreating the inorganic filler surface with the coupling agent and then kneading with the resin, or mixing the coupling agent with the resin and then kneading the inorganic filler.

The curable resin composition of the embodiment can include known additives as needed. Specific examples of additives that can be used include polybutadiene and modified products thereof, modified products of acrylonitrile copolymers, polyphenylene ether, polystyrene, polyethylene, polyimide, fluorine resins, maleimide-based compounds, cyanate ester-based compounds, silicone gel, silicone oil, and colorants such as carbon black, phthalocyanine blue, phthalocyanine green, and the like.

The curable resin composition of the embodiment is obtained by uniformly mixing the above components. The production method of the curable resin composition of the embodiment is not particularly limited, but can be obtained, for example, by sufficiently mixing the epoxy resin with the curing agent, curing accelerator, inorganic filler, release agent, silane coupling agent, additives, and the like using an extruder, kneader, roll, planetary mixer, or the like until uniform.

The obtained curable resin composition can take various forms such as resin sheets, prepregs, and the like depending on the molding method thereof. The prepreg form can be obtained, for example, by having the curable resin composition and/or resin sheet of the embodiment be heated and melted to reduce viscosity and be impregnated in the fiber substrate.

The curable resin composition of the embodiment can be dissolved in solvents such as toluene, xylene, acetone, methyl ethyl ketone, methyl isobutyl ketone, dimethylformamide, dimethylacetamide, N-methylpyrrolidone, and the like as needed to form a varnish-like composition (hereinafter also simply referred to as varnish), and the prepreg can be prepared by impregnating substrates such as glass fiber, carbon fiber, polyester fiber, polyamide fiber, alumina fiber, paper, and the like with the varnish and heating and drying. The solvent used in this case occupies 10 to 70% by weight, preferably 15 to 70% by weight, in the mixture of the curable resin composition of the embodiment and the solvent.

A carbon fiber reinforced plastic (CFRP) can be obtained by cutting and laminating the above prepreg into a desired shape, and then heat-curing the epoxy resin composition while applying pressure to the laminate using press molding, autoclave molding, sheet winding molding, or other methods. Additionally, copper foil or organic films can also be laminated during the lamination of the prepreg.

CFRP molding methods can also be obtained by molding using known methods in addition to the above methods. For example, resin transfer molding technology (RTM method) can also be used, in which carbon fiber substrate (usually carbon fiber fabric is used) is cut, laminated, and shaped to prepare a preform (preformed body before resin impregnation), the preform is disposed in a molding die and the die is closed, resin is injected to impregnate and cure the preform, and then the die is opened to remove the molded product. Additionally, as a type of the RTM method, for example, the VaRTM method, Seeman's Composite Resin Infusion Molding Process (SCRIMP) method, Controlled Atmospheric Pressure Resin Infusion (CAPRI) method described in Japanese Patent Publication No. 2005-527410 that evacuates the resin supply tank to a pressure lower than atmospheric pressure, uses circulation compression, and controls net molding pressure to more appropriately control the resin injection process, particularly the VaRTM method, can also be used. Furthermore, a film stacking method in which a fiber substrate is sandwiched between resin sheets (films), a method of adhering powdered resin to a reinforcing fiber substrate for improved impregnation, a molding method using a fluidized bed or fluid slurry method in the process of mixing resin with a fiber substrate (Powder Impregnated Yarn), and a method of blending resin fibers with a fiber substrate can also be used.

Examples of carbon fiber include acrylic, pitch-based, and rayon-based carbon fibers, among which acrylic carbon fiber with high tensile strength is preferably used. As forms of carbon fiber, twisted yarn, untwisted yarn, and non-twisted yarn can be used, but untwisted yarn or non-twisted yarn is preferably used because of the good balance between moldability and strength characteristics of fiber-reinforced composite materials.

The cured product of the curable resin composition of the embodiment can be used in various applications other than the above-mentioned CFRP applications, for example, adhesives, paints, coating agents, molding materials (including sheets, films, CFRP, etc.), semiconductor device encapsulant, liquid crystal display device encapsulant, organic EL device encapsulant, electrical and electronic components such as printed wiring boards (BGA substrates, buildup substrates, etc.), 3D printing, and additives for other resins.

Examples of the adhesives include adhesives for civil engineering, construction, automotive, general office, and medical use, as well as adhesives for electronic materials. Among the aforementioned, adhesives for electronic materials include interlayer adhesives for multilayer substrates such as buildup substrates, die bonding agents, semiconductor adhesives such as underfill, BGA reinforcement underfill, anisotropic conductive films (ACF), mounting adhesives such as anisotropic conductive paste (ACP), and the like, which are applicable to various uses.

In the case of applying the curable resin composition of the embodiment to a semiconductor device encapsulant, the curable resin composition of the embodiment is applied to a lead frame or semiconductor package substrate equipped with semiconductor elements, which is disposed in a mold and molded by the melt casting method, transfer molding method, injection molding method, compression molding method, or the like, and further heated at 80 to 200°C for 2 to 10 hours to obtain a cured product. Examples of semiconductor devices manufactured using the encapsulant include potting, dipping, transfer mold encapsulation for capacitors, transistors, diodes, light-emitting diodes, ICs, LSIs, etc., potting encapsulation for COB, COF, TAB, etc. of ICs and LSIs, underfill for flip chips, and encapsulation (including reinforcement underfill) during mounting of IC packages such as QFP, BGA, and CSP.

In the case of applying the curable resin composition of the embodiment to printed wiring board applications, the prepreg can also be obtained by having the curable resin composition be heated and melted to reduce viscosity and then be impregnated into reinforcing fibers such as glass fiber and polyamide fiber. Specific examples thereof include glass fibers such as E glass cloth, D glass cloth, S glass cloth, Q glass cloth, spherical glass cloth, NE glass cloth, and T glass cloth, and/or organic fibers, but are not particularly limited thereto. The shape of the substrate is not particularly limited, and examples include woven fabric, non-woven fabric, roving, chopped strand mat, and the like. As weaving methods for woven fabric, plain weave, huck weave, twill weave, and the like are known, and the known methods can be appropriately selected and used according to the intended application and performance. Additionally, glass woven fabric that has been subjected to fiber opening treatment or surface treatment with a silane coupling agent or the like is preferably used. The thickness of the substrate is not particularly limited, but is preferably about 0.01 to 0.4 mm. The prepreg can also be obtained by impregnating the reinforcing fiber with the varnish and heating and drying, and copper clad laminate (CCL) can be prepared based on the prepreg. By hot press molding the obtained prepreg and CCL, a laminate using the curable resin composition of the embodiment can also be prepared. The laminate is not particularly limited as long as it includes one or more prepregs, and may have any other layers. Additionally, a sheet-like adhesive can be obtained by applying the varnish on a release film and removing the solvent under heating to achieve B-staging. This sheet-like adhesive can be used as an interlayer insulating layer in multilayer substrates or as an adhesive sheet in the case of mounting semiconductors. The curable resin composition of the embodiment can also be suitably used for special substrate materials such as package substrates and high density interconnects (HDI). Example

The present invention will be described more specifically below by citing synthesis examples and examples. The materials, processing contents, processing procedures, etc. shown below can be appropriately changed without departing from the spirit of the present invention. Therefore, the scope of the present invention should not be interpreted in a limited manner by the specific examples shown below. Hereinafter, unless otherwise specified, parts are parts by weight.

Various analytical methods were performed under the following conditions.
· Epoxy equivalent
   Measured by the method described in JIS K-7236, and the unit is g/eq.
· Softening point
   Measured by the method in accordance with JIS K-7234, and the unit is ° C.
· Melt viscosity
   Measured by ICI melt viscosity (150° C) cone plate method, and the unit is Pa·s.
· Biomass content analysis (accelerated gravimetric analysis)
   Measured and calculated in accordance with ASTM D6866-21. The unit is %.

### [Synthesis Example 1]

In a flask including a stirrer, reflux condenser, and stirring device, 254 parts by weight of phenol, 63 parts by weight of water, and 27 parts by weight of sodium hydroxide were charged, and after stirring and dissolving, the mixture was heated to 110°C, and 44 parts by weight of furfural was added dropwise over 2 hours. After reacting at 110°C for 3 hours, the temperature was raised to 145°C. During the temperature rise, water that distilled out was removed from the system. After reaching 145°C, the reaction was continued for 4 hours. Then, the mixture was cooled to 80°C, 63 parts by weight of water was charged, and 4 parts by weight of phosphoric acid and 63 parts by weight of 35% hydrochloric acid were added for neutralization. After repeated washing with water, unreacted phenol was distilled off under heating and reduced pressure, and 109 parts by weight of phenolic resin was obtained. To 78 parts by weight of the obtained phenolic resin, 254 parts by weight of epichlorohydrin (ECH, hereinafter the same), 64 parts by weight of dimethyl sulfoxide (DMSO, hereinafter the same), and 13 parts by weight of water were charged into a reaction vessel, and after heating, stirring, and dissolving, while maintaining the temperature at 45°C, 23 parts by weight of flake sodium hydroxide was charged in portions over 2 hours. Thereafter, the reaction was further continued at 45°C for 2 hours and at 70°C for 60 minutes. Then, after repeated washing with water to remove by-product salts and dimethyl sulfoxide, excess epichlorohydrin was distilled off from the oil layer under heating and reduced pressure, and 218 parts by weight of methyl isobutyl ketone was added to the residue and dissolved. The methyl isobutyl ketone solution was heated to 70°C, 7 parts by weight of 30% sodium hydroxide aqueous solution was added, and after reacting for 1 hour, washing of the reaction solution with water was repeated until the washing solution became neutral. Then, the methyl isobutyl ketone was distilled off from the oil layer under heating and reduced pressure to obtain 97 parts by weight of epoxy resin A represented by the above formula (1). The epoxy equivalent was 214 g/eq., the softening point was 49°C, the ICI melt viscosity was 0.04 Pa·s, the average value n of the number of repetitions from GPC was 2.1, and the biomass content was 25%. The GPC chart of epoxy resin A is shown in FIG. 1.

### [Synthesis Example 2]

In a four-necked flask, 49.1 g of toluene and 25.8 parts of α-terpinene (manufactured by Guangxi Jiexin Spice Co., Ltd.) were added and heated to 85°C with stirring. To the solution, 16.7 parts of maleic anhydride was added in four portions over 1 hour. After completion of the addition, the mixture was stirred at 85°C for 1 hour. After completion of the reaction, 37 parts of acid anhydride A was obtained by concentration under reduced pressure at 185°C.

### [Example 1]

Using epoxy resin A obtained in Synthesis Example 1 as the main agent, acid anhydride A obtained in Synthesis Example 2 as the curing agent, and 2E4MZ (2-ethyl-4-methylimidazole, manufactured by Shikoku Chemicals Corporation) as the anionic polymerization initiator, the components were blended and kneaded at the weight ratio shown in the blend composition of Table 1, and cured under curing conditions of 160°C for 6 hours to prepare a cured product. The biomass content of the cured product was 48.6%.

### [Comparative Example 1]

Using epoxy resin A obtained in Synthesis Example 1 as the main agent, Kayahard MCD (methylnadic anhydride, manufactured by Nippon Kayaku Co., Ltd.) as the curing agent, and 2E4MZ (2-ethyl-4-methylimidazole, manufactured by Shikoku Chemicals Corporation) as the anionic polymerization initiator, the components were blended and kneaded at the weight ratio shown in the blend composition of Table 1, and cured under curing conditions of 160°C for 6 hours to prepare a cured product. The biomass content of the cured product was 15.2%.

### [Comparative Example 2]

Using epoxy resin A obtained in Synthesis Example 1 as the main agent, PN (phenol novolac resin, manufactured by Meiwa Kasei Co., Ltd., hydroxyl equivalent 103 g/eq.) as the curing agent, and TPP (triphenylphosphine) as the curing accelerator, the components were blended and kneaded at the weight ratio shown in the blend composition of Table 1, and cured under curing conditions of 180°C for 6 hours to prepare a cured product. The biomass content of the cured product was 16.6%.

The measurement of physical property values was conducted under the following conditions.

### <Heat Resistance (Tg) Measurement Conditions>

Dynamic viscoelasticity measuring instrument: TA-instruments, DMA-Q800
Measurement temperature range: 25~300°C
Heating rate: 2°C/min
Tg: The peak point of Tanδ was taken as Tg.

### <Dielectric Constant and Dielectric Loss Tangent Test>

A test was conducted using a 10GHz cavity resonator manufactured by AET Co., Ltd. at 25° C by the cavity resonator perturbation method. The sample size was 2.5mm width × 50mm length, and the test was conducted with a thickness of 0.3mm.

**[Table 1]**

| | Example 1 | Comparative Example 1 | Comparative Example 2 |
|---|---|---|---|
| Epoxy resin A | 48 | 57 | 68 |
| 2E4MZ | 1 | 1 | - |
| Acid anhydride A | 52 | - | - |
| Kayahard MCD | - | 43 | - |
| PN | - | - | 32 |
| TPP | - | - | 1 |
| Evaluation results | | | |
| Tg (°C) | 208 | 207 | 145 |
| Dielectric constant | 2.57 | 2.73 | 3 |
| Dielectric loss tangent | 0.012 | 0.016 | 0.033 |
| Biomass content (%) | 48.6 | 15.2 | 16.6 |

From the results in Table 1, it was confirmed that Example 1 has high biomass content and is exemplary in high heat resistance and low dielectric properties.

## Claims

1. A curable resin composition, comprising an epoxy resin represented by the following formula (1) and a biomass-modified acid anhydride 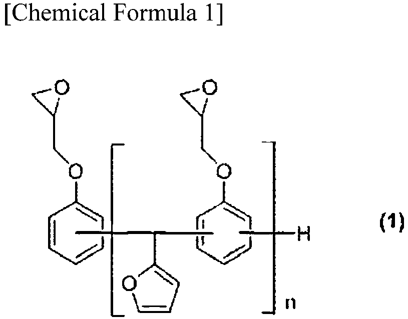 (in formula (1), n is an average value of the number of repetitions and represents a real number where 1<n<15).

2. The curable resin composition according to claim 1, wherein the biomass-modified acid anhydride is at least one selected from myrcene-modified acid anhydride, farnesene-modified acid anhydride, and α-terpinene-modified acid anhydride.

3. The curable resin composition according to claim 1, wherein biomass content of the biomass-modified acid anhydride is 20% or more.

4. The curable resin composition according to claim 1, wherein ICI viscosity (150°C) of the epoxy resin is 0.01 to 0.20 Pa·s.

5. The curable resin composition according to claim 1, wherein biomass content is 20% or more.

6. The curable resin composition according to any one of claims 1 to 5, which is for a carbon fiber reinforced plastic.

7. The curable resin composition according to any one of claims 1 to 5, which is for a semiconductor device encapsulant.

8. The curable resin composition according to any one of claims 1 to 5, which is for a printed wiring board.

9. A cured product, obtained by curing the curable resin composition according to any one of claims 1 to 5.
